(19) Europäisches Patentamt
European Patent Office
Office européen des brevets

(11) **EP 4 583 341 A1**

(12) **EUROPEAN PATENT APPLICATION**
published in accordance with Art. 153(4) EPC

(43) Date of publication:
**09.07.2025 Bulletin 2025/28**

(21) Application number: 23859789.2

(22) Date of filing: **19.06.2023**

(51) International Patent Classification (IPC):
*H02J 1/00* $^{(2006.01)}$    *G01R 31/12* $^{(2020.01)}$
*H02H 3/05* $^{(2006.01)}$    *H02H 7/26* $^{(2006.01)}$
*H02H 11/00* $^{(2006.01)}$    *H02J 3/38* $^{(2006.01)}$
*H02J 7/35* $^{(2006.01)}$

(52) Cooperative Patent Classification (CPC):
G01R 31/12; H02H 3/05; H02H 7/26; H02H 11/00;
H02J 1/00; H02J 3/38; H02J 7/35

(86) International application number:
**PCT/JP2023/022616**

(87) International publication number:
**WO 2024/048019 (07.03.2024 Gazette 2024/10)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **02.09.2022 JP 2022140288
02.09.2022 JP 2022140289
02.09.2022 JP 2022140290
06.10.2022 JP 2022161563**

(71) Applicant: **Kaneka Corporation
Osaka-shi, Osaka 530-8288 (JP)**

(72) Inventor: **NISHIYAMA, Haruo
Osaka-shi, Osaka 530-8288 (JP)**

(74) Representative: **Hoffmann Eitle
Patent- und Rechtsanwälte PartmbB
Arabellastraße 30
81925 München (DE)**

(54) **ELECTRIC POWER SUPPLY SYSTEM**

(57)    The present invention provides a power supply system capable of promptly extinguishing arc discharge when the arc discharge occurs.

The power supply system includes a power supply module; a converter portion that includes a boost circuit in which a reactor portion and a first switching element are connected in series, and a rectifying portion that allows a flow of a current from the converter circuit side to the inverter portion side and interrupts a flow of a current from the inverter portion side to the converter circuit side; an inverter portion that includes an interrupter; a series arc detector; and a connection terminal, in which a transformation operation of boosting or stepping down an input voltage from the power supply module by switching between an ON state and an OFF state of the first switching element and outputting power to the inverter portion can be executed, and when the series arc detector detects series arc discharge, the first switching element is put into the OFF state and then maintained and distribution of power flowing between the converter portion and the connection terminal is interrupted by the interrupter or the rectifying portion.

**EP 4 583 341 A1**

# FIG. 2

START

S1-1  m=0, n=0

S1-2  NORMAL DRIVING

S1-3  IS SERIES ARC DETECTED? — Yes → S1-11 SERIES STOP DRIVING

No ↓

S1-4  IS PARALLEL ARC DETECTED? — No

Yes ↓

S1-5  PARALLEL STOP DRIVING

S1-6  HAS FIRST TIME T1 ELAPSED? — No

Yes ↓

S1-7  m<a? — No

Yes ↓

S1-8  m=m+1

S1-9  END PARALLEL STOP DRIVING

S1-10  IS THERE DRIVING END REQUEST? — No

Yes ↓

END

S1-11  SERIES STOP DRIVING

S1-12  HAS SECOND TIME T2 ELAPSED? — No

Yes ↓

S1-13  n<b? — No

Yes ↓

S1-14  n=n+1

S1-15  END SERIES STOP DRIVING

S1-16  STOP DRIVING

S1-17  HAS PREDETERMINED PERIOD T3 ELAPSED? — No

Yes ↓

S1-18  m=0, n=0

**Description**

TECHNICAL FIELD

The present invention relates to a power supply system including a power supply module such as a solar cell module and a power conversion device.

BACKGROUND ART

In the related art, a solar power generation system includes a solar cell module and a power conditioner, and DC power generated by the solar cell module can be converted into AC power by the power conditioner and supplied to a commercial power supply system.

In the solar power generation system in the related art, a fire may rarely occur after several years have elapsed after installation. Such a fire is often caused mainly by arc discharge that occurs at locations with aging deterioration where cable pinching during installation, damage to the cable, or a contact failure in a connector portion is left unaddressed.

The arc discharge can be roughly classified into series arc discharge and parallel arc discharge depending on a place where the arc discharge occurs on the circuit.

The series arc discharge occurs in a case where a current passes through a conductive wire in a series circuit, and the parallel arc discharge occurs in a case where a current passes between two conductive wires connected in parallel in a parallel circuit.

In a case where any arc discharge occurs, it is necessary to extinguish the arc discharge promptly.

Therefore, in a solar power generation system of Patent Document 1, a breaker for interrupting arc discharge is provided between a solar cell module and a power conditioner, and when series arc discharge is detected, the arc discharge is interrupted by the breaker and promptly extinguished.

In addition, a power conditioner of Patent Document 2 measures an input current and an output current of a DC/AC inverter, creates a signal for calculation based on the input current and the output current, performs calculation based on the signal for calculation, and determines the presence or absence of arc discharge.

In the power conditioner of Patent Document 2, in a case where it is determined that there is arc discharge, an operation of interrupting the power supply from solar power generation means and an operation of interrupting the connection to the commercial power supply system are executed.

PRIOR ART DOCUMENTS

PATENT DOCUMENTS

Patent Document 1: JP 6597394 A
Patent Document 2: JP 2020-36511 A

DISCLOSURE OF INVENTION

TECHNICAL PROBLEM

In a general power conditioner, DC power generated by a solar cell module is boosted in voltage by a DC/DC converter, the boosted DC power is converted into AC power by a DC/AC converter, and the AC power is output to a commercial power supply system.

It is preferable that the above-described response to the arc discharge can cope with arc discharge without making a significant change to a structure of the power conditioner while maintaining the function as the power conditioner.

In addition, there are arc discharge that occurs for a long time, is likely to lead to a fire, and has a high risk, and arc discharge that is extinguished in a short time, is less likely to lead to a fire, and is not highly dangerous.

It is preferable to be able to discriminate the risk of arc discharge without significantly changing a structure of the power conditioner while maintaining the function as the power conditioner when the arc discharge occurs, because it is easy to cope with the arc discharge when the arc discharge occurs.

Therefore, an object of the present invention is to provide a power supply system capable of promptly extinguishing arc discharge when the arc discharge occurs. In addition, another object of the present invention is to provide a power supply system capable of discriminating the risk of arc discharge when the arc discharge occurs.

SOLUTION TO PROBLEM

An aspect of the present invention for solving the above-described problems is a power supply system including a power supply module; a power conversion device; and a series arc detector, wherein the power conversion device includes a converter portion, an inverter portion, and a connection terminal electrically connectable to a system power supply portion, the converter portion includes a converter circuit in which a reactor portion and a first switching element are connected in series, and is capable of executing a transformation operation in which an input voltage from the power supply module is boosted or stepped down by switching the first switching element an ON state or an OFF state and power is outputted to the inverter portion, the converter portion includes a rectifying portion that allows a flow of a current from the converter circuit side to the inverter portion side and interrupts a flow of a current from the inverter portion side to the converter circuit side, the inverter portion includes an interrupter capable of interrupting a supply of power to the connection terminal side of the inverter portion, the series arc detector is capable of detecting series arc discharge in a portion closer to the power supply module than to the power conversion device, and when the series arc detector detects series arc discharge, the transformation operation is stopped, and a series arc interruption operation is executed, wherein the series arc interruption operation keeps the first switching element in the OFF state or put it into the OFF state and then maintains and interrupts distribution of power flowing between the converter portion and the connection terminal by the interrupter or the rectifying portion.

According to the present aspect, in a case where the series arc discharge is detected and, with reference to the rectifying portion, the voltage on the converter circuit side is the same as or greater than the voltage on the inverter portion side, by putting the first switching element into the OFF state, and interrupting the distribution of power flowing between the converter portion and the connection terminal by the interrupter, it is possible to prevent the short circuit between the positive electrode side and the negative electrode side of the power supply module, it is not necessary to provide a breaker between the power supply module and the power conversion device, and it is possible to promptly extinguish the series arc discharge when the series arc discharge occurs without increasing the size of the entire system.

On the other hand, in a case where the series arc discharge is detected and, with reference to the rectifying portion, the voltage on the converter circuit side is smaller than the voltage on the inverter portion side, the current does not flow from the converter circuit side to the inverter portion side by the rectifying portion, and the distribution of power flowing between the converter portion and the connection terminal is interrupted. Therefore, by putting the first switching element into the OFF state, it is possible to prevent the short circuit between the positive electrode side and the negative electrode side of the power supply module, it is not necessary to provide a breaker between the power supply module and the power conversion device, and it is possible to promptly extinguish the series arc discharge when the series arc discharge occurs without increasing the size of the entire system.

In a preferable aspect, the converter portion is a boost converter portion, the converter circuit is a boost circuit, the boost converter portion is capable of executing a boost operation of boosting an input voltage from the power supply module by switching between the ON state and the OFF state of the first switching element and outputting power to the inverter portion, and the series arc interruption operation, when the series arc detector detects series arc discharge, stops the boost operation, keeps the first switching element in the OFF state or puts it into the OFF state and then maintains, and interrupts the distribution of power flowing between the boost converter portion and the connection terminal by the interrupter or the rectifying portion.

In a preferable aspect, the power supply system further includes a parallel arc detector that detects parallel arc discharge in a portion closer to the power supply module than to the power conversion device, wherein when the parallel arc detector detects parallel arc discharge, the boost operation is stopped, and a parallel arc interruption operation in which the first switching element is kept in the ON state or is put into the ON state and then maintained is executed.

In a preferable aspect, the boost converter portion includes a capacitor portion, and the capacitor portion is connected in parallel to the first switching element.

In the related art, maintenance has been performed immediately when arc discharge occurs.

However, in a case where the arc discharge can be extinguished early, the occurrence of the arc discharge does not lead to a fire, and the system can be used continuously thereafter in many cases.

In a preferable aspect, when a predetermined time elapses after the series arc detector detects the series arc discharge, the boost operation is resumed.

Here, the series arc discharge often continues to occur once it occurs, and in a case where the series arc discharge frequently occurs, there is a high possibility that a problem occurs in the system.

In a preferable aspect, in a case where the series arc interruption operation is performed a predetermined number of times or more, a driving stop operation in which driving of the power conversion device is stopped is executed.

In a preferable aspect, when a predetermined time elapses after the parallel arc detector detects the parallel arc discharge, the boost operation is resumed.

In a preferable aspect, in a case where the parallel arc interruption operation is performed a predetermined number of times or more, a driving stop operation in which driving of the power conversion device is stopped is executed.

Incidentally, when the power conversion device is stopped for a relatively long period, the arc discharge on the power supply module side is also settled in many cases.

In a preferable aspect, when a predetermined period elapses after the driving stop operation is executed, the driving stop operation is ended.

In a preferable aspect, the inverter portion includes a second switching element, a third switching element, a fourth switching element, and a fifth switching element, the inverter portion includes a full-bridge circuit in which the second switching element and the fifth switching element, and the third switching element and the fourth switching element are respectively arranged diagonally, and when the series arc detector detects the series arc discharge, at least one combination of a combination of the second switching element and the third switching element and a combination of the fourth switching element and the fifth switching element is put into the OFF state to interrupt the distribution of power flowing between the boost converter portion and the connection terminal.

In a preferable aspect, the power supply module is at least one module selected from a solar cell module, a fuel cell module, and a power storage module.

In a preferable aspect, the power supply system further includes a plurality of power supply modules, wherein the power conversion device includes a plurality of boost converter portions, the plurality of boost converter portions are electrically connected to the plurality of power supply modules, respectively, the series arc detector is capable of detecting series arc discharge in a portion closer to each power supply module than to the power conversion device, and in a case where the series arc detector detects series arc discharge in a portion on one power supply module side and a voltage on the boost circuit side in the boost converter portion corresponding to the one power supply module, with reference to the rectifying portion, is smaller than a voltage on the inverter portion side, in the boost converter portion corresponding to the one power supply module, the boost operation is stopped and the first switching element is kept in the OFF state or is put into the OFF state and then maintained, and in the boost converter portions corresponding to the other power supply modules, the boost operation is continued.

According to the present aspect, even when series arc discharge occurs in one power supply module, the driving of the other power supply modules can be continued.

A preferable aspect is a power supply system including a power supply module; a power conversion device; a first wiring portion that electrically connects the power supply module and the power conversion device; and arc detection means, wherein the arc detection means is capable of detecting arc discharge in the first wiring portion in a state of not being in contact with the first wiring portion, and in a case where the arc detection means detects arc discharge, a risk degree determination operation is executed, in the risk degree determination operation, duration of the arc discharge after the arc discharge detection is compared with a first threshold value, and whether or not the arc discharge that has occurred reaches a first criteria for risk assessment is discriminated based on a result of the comparison with the first threshold value.

In a preferable aspect, in a case where it is not discriminated that the arc discharge that has occurred reaches the first criteria as a result of comparing the duration with the first threshold value, the risk degree determination operation compares a risk discrimination work amount with a preset second threshold value, and discriminates whether or not the arc discharge that has occurred reaches a second criteria for risk assessment based on a result of comparison with the second threshold value, and the risk discrimination work amount is calculated based on a current setpoint according to an output of the power supply module, a voltage setpoint based on a voltage at a time of occurrence of the arc discharge, and the duration.

In a preferable aspect, the current setpoint, the voltage setpoint, and the second threshold value are set based on information input by information input means that receives an input of information from a user, or information transmitted from an external device.

An aspect of the present invention is a power supply system including a power supply module; a power conversion device; a first wiring portion that electrically connects the power supply module and the power conversion device; and arc detection means, wherein the arc detection means is capable of detecting arc discharge in the first wiring portion in a state of not being in contact with the first wiring portion, and in a case where the arc detection means detects arc discharge, a risk degree determination operation is executed, in the risk degree determination operation, duration of the arc discharge after the arc discharge detection is compared with a first threshold value, and whether or not the arc discharge that has occurred reaches a first criteria for risk assessment is discriminated based on a result of the comparison with the first threshold value.

According to the present aspect, the arc detection means can acquire the presence or absence of occurrence of the arc discharge in the first wiring portion and the duration of the arc discharge when the arc discharge occurs, in a state of not being in contact with the first wiring portion, and it is easy to retrofit the arc detection means. Furthermore, since it is possible to discriminate, with a simple configuration, whether or not the arc discharge that has occurred has a high risk (large-scale) enough to lead to a fire, it is possible to appropriately deal with arc discharge that has occurred.

An aspect of the present invention is a power supply system including a power generation module; a power conversion device; a power storage module; a bidirectional converter portion; and arc detection means, wherein a first wiring portion that electrically connects the power generation module and the power conversion device, a second wiring portion that electrically connects the power storage module and the bidirectional converter portion, and a third wiring portion that electrically connects the bidirectional converter portion and the power conversion device are provided, the arc detection means is capable of detecting arc discharge in at least one wiring portion selected from the first wiring portion, the second wiring portion, and the third wiring portion in a state of not being in contact with the one wiring portion, and in a case where the arc detection means detects arc discharge in the one wiring portion, a risk degree determination operation is executed, in the risk degree determination operation, duration until the arc discharge is extinguished from the detection of the arc discharge in the one wiring portion is compared with a first threshold value, and whether or not the arc discharge that has occurred reaches a first criteria for risk assessment is discriminated based on a result of the comparison with the first threshold value.

In the present aspect, the arc detection means can acquire the presence or absence of occurrence of the arc discharge in the target wiring portion and the occurrence time when the arc discharge occurs, in a state of not being in contact with the target wiring portion, and it is easy to retrofit the arc detection means. Furthermore, since it is possible to discriminate, with a simple configuration, whether or not the arc discharge that has occurred has a high risk (large-scale) enough to lead to a fire, it is possible to appropriately deal with arc discharge that has occurred.

EFFECT OF INVENTION

With the power supply system of the present invention, it is possible to promptly extinguish arc discharge when the arc discharge occurs.

With the power supply system of the present invention, it is possible to discriminate a risk of arc discharge when the arc discharge occurs.

BRIEF DESCRIPTION OF DRAWINGS

Fig. 1 is an explanatory diagram of a power supply system according to a first embodiment of the present invention, Fig. 1A is a block diagram of the power supply system, and Fig. 1B is a circuit diagram of the power supply system.

Fig. 2 is a flowchart of a driving operation of the power supply system of Fig. 1.

Fig. 3 is a flowchart during series stop driving of the power supply system in Fig. 1.

Fig. 4 is a circuit diagram of a power supply system according to a second embodiment of the present invention.

Fig. 5 is a block diagram schematically illustrating a power supply system according to a third embodiment of the present invention.

Fig. 6 is a block diagram illustrating a part of the power supply system of Fig. 5.

Fig. 7 is a flowchart illustrating a danger discrimination operation executed by the power supply system of Fig. 5.

Fig. 8 is a flowchart of an arc interruption operation of Fig. 5.

Fig. 9 is a flowchart during series stop driving of a power supply system according to another embodiment of the present invention.

BEST MODE FOR CARRYING OUT THE INVENTION

Hereinafter, embodiments of the present invention will be described in detail.

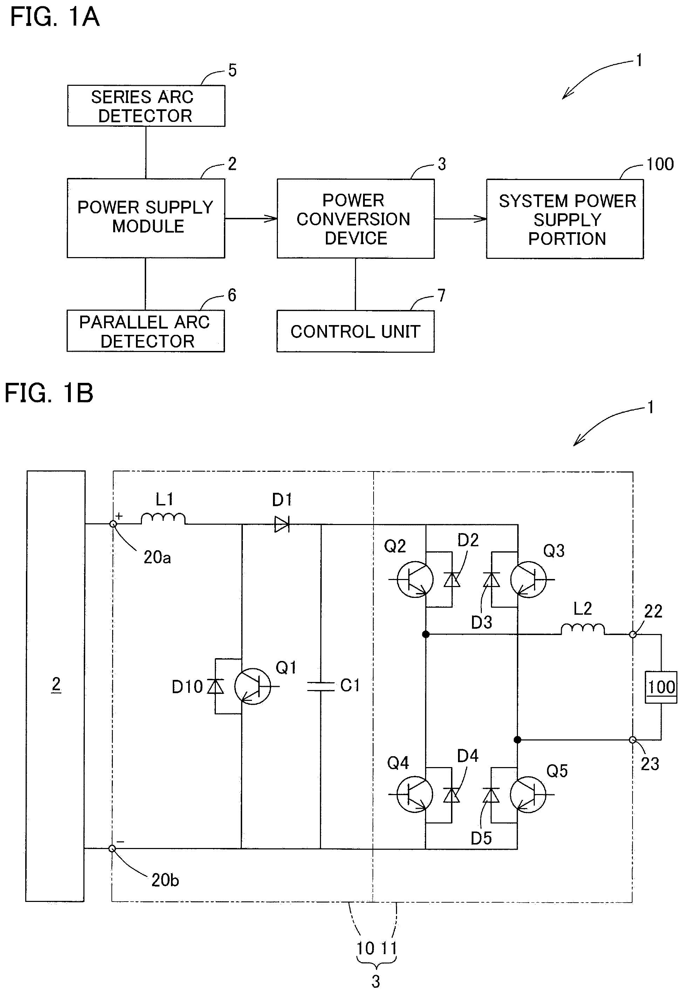

As illustrated in Fig. 1A, a power supply system 1 according to a first embodiment of the present invention includes a power supply module 2, a power conversion device 3, a series arc detector 5, a parallel arc detector 6, and a control unit 7.

The power supply system 1 supplies DC power generated by the power supply module 2 to the power conversion device 3, converts the DC power into AC power by the power conversion device 3, and supplies the AC power to a system power supply portion 100.

(Power Supply Module 2)

The power supply module 2 is a power generation module that generates power using renewable energy such as a solar cell module or a fuel cell module, or a power storage module such as a secondary battery module. In the present embodiment, the power supply module 2 is a power generation module, and specifically, a solar cell module is used.

In the power supply module 2, a plurality of solar cell strings are connected in parallel, and each solar cell string has a plurality of solar cells connected in series.

(Power Conversion Device 3)

As illustrated in Fig. 1B, the power conversion device 3 includes a boost converter portion 10 (converter portion), an inverter portion 11, a module-side connection terminal 20 (20a, 20b), and system-side connection terminals 22 and 23.

(Boost converter portion 10)

As illustrated in Fig. 1B, the boost converter portion 10 is connected to the power supply module 2 via a positive-electrode-side input terminal 20a and a negative-electrode-side input terminal 20b.

The boost converter portion 10 is a non-isolated DC-DC converter including a reactor portion L1, a switching element Q1, a diode portion D1 (rectifying portion), and a capacitor portion C1.

The boost converter portion 10 is a so-called chopper type DC-DC converter.

The boost converter portion 10 includes a boost circuit (converter circuit) in which the positive-electrode-side input terminal 20a, the reactor portion L1, the switching element Q1, and the negative-electrode-side input terminal 20b are connected in series, and boosts (transforms) a voltage by switching an ON state and an OFF state of the switching element Q1 by a PWM control signal from the control unit 7.

That is, in the boost converter portion 10, by putting the switching element Q1 into the ON state, the boost circuit forms a closed circuit and stores energy in the reactor portion L1, and by putting the switching element Q1 into the OFF state, the boost circuit forms an open circuit and releases the energy stored in the reactor portion L1.

In addition, the boost converter portion 10 controls the duty ratio by the PWM control signal from the control unit 7, thereby boosting the voltage to a desired voltage.

In the boost converter portion 10, the positive-electrode-side input terminal 20a, the reactor portion L1, the diode portion D1, the capacitor portion C1, and the negative-electrode-side input terminal 20b are connected in series, and the switching element Q1 is connected in parallel to the diode portion D1 and the capacitor portion C1.

The switching element Q1 can switch between the ON state and the OFF state by the PWM control signal from the control unit 7, and a transistor such as a bipolar transistor, an electrolytic effect transistor, or an insulated gate bipolar transistor (IGBT), a relay switch, or the like can be used.

The diode portion D1 is a rectifying portion that rectifies a current in one direction, allows a flow of a current from the boost circuit side to the inverter portion 11 side, and can interrupt a flow of a current from the inverter portion 11 to the boost circuit side.

In the boost converter portion 10, a diode portion D10 is connected in parallel to the switching element Q1.

The diode portion D10 allows a flow of a current in a direction opposite to a flow of a current in the ON state of the switching element Q1, and can interrupt the flow of the current in the same direction.

The diode portion D10 is a rectifying portion that rectifies a current in one direction, allows a flow of a current from the negative-electrode-side input terminal 20b side to the positive-electrode-side input terminal 20a side, and can interrupt a flow of a current from the positive-electrode-side input terminal 20a side to the negative-electrode-side input terminal 20b side.

(Inverter portion 11)

The inverter portion 11 is a part that alternately converts DC power and AC power.

As illustrated in Fig. 1B, the inverter portion 11 is connected to the system power supply portion 100 via the system-side connection terminal 22 (connection terminal) and the system-side connection terminal 23 (connection terminal).

The inverter portion 11 includes a full-bridge circuit in which switching elements Q2 and Q5 and switching elements Q3 and Q4 are respectively arranged diagonally, which includes a first arm in which the switching element Q2 and the switching element Q4 are connected in series, and a second arm in which the switching element Q3 and the switching element Q5 are connected in series, and in which the first arm and the second arm are connected in parallel, and AC power is output from a midpoint of the first arm and a midpoint of the second arm.

In the inverter portion 11, when the system-side connection terminals 22 and 23 are connected to the system power supply portion 100, the switching element Q2, a reactor portion L2, the system power supply portion 100, and the switching element Q5 are connected in series, and the switching element Q3, the system power supply portion 100, the reactor portion L2, and the switching element Q4 are connected in series.

The inverter portion 11 constitutes an interrupter that interrupts power input from the boost converter portion 10 by the switching elements Q2 to Q5.

That is, by putting the switching elements Q2 and Q3 on the positive electrode side of the power supply module 2 and/or the switching elements Q4 and Q5 on the negative electrode side of the power supply module 2 into the OFF state, the inverter portion 11 can interrupt the distribution of power from the boost converter portion 10 side to the system-side connection terminals 22 and 23 side.

The switching elements Q2 to Q5 can switch between the ON state and the OFF state by the PWM control signal from the control unit 7, and a transistor such as a bipolar transistor, an electrolytic effect transistor, or an insulated gate bipolar transistor (IGBT), a relay switch, or the like can be used.

In the inverter portion 11, diode portions D2 to D5 are connected in parallel to the switching elements Q2 to Q5.

The diode portions D2 to D5 allow a flow of a current in a direction opposite to a flow of a current in the ON state of the switching elements Q2 to Q5, respectively, and can interrupt the flow of the current in the same direction.

The inverter portion 11 can execute a power conversion operation of converting the DC power into the AC power in accordance with an ON/OFF cycle of each of the switching elements Q2 to Q5 by the PWM control signal from the control unit 7.

(Series Arc Detector 5)

The series arc detector 5 is a part that detects series arc discharge when the series arc discharge occurs in a portion closer to the power supply module 2 than to the input terminals 20a and 20b of the power conversion device 3.

That is, detection targets of the series arc detector 5 are the series arc discharges of not only the power supply module 2 but also wiring lines or the like connecting the power supply module 2 and the input terminals 20a and 20b.

(Parallel Arc Detector 6)

The parallel arc detector 6 is a part that detects parallel arc discharge when the parallel arc discharge occurs in a portion closer to the power supply module 2 than to the input terminals 20a and 20b of the power conversion device 3.

That is, detection targets of the parallel arc detector 6 are the parallel arc discharges of not only the power supply module 2 but also wiring lines or the like connecting the power supply module 2 and the input terminals 20a and 20b.

(Control Unit 7)

The control unit 7 includes, as a hardware configuration, a computer including a central processing unit including a control device that controls each device and an arithmetic device that performs an arithmetic operation on data, a storage device that stores data, an input device that inputs data from the outside, and an output device that outputs data to the outside.

That is, the control unit 7 can transmit and receive signals to and from an external computer (server, host control device), and can store information transmitted from the external computer. Furthermore, using information input means (keyboard, pointing device, remote controller, touch panel, and the like) that receives an input of information from a user, the user can input information, and the input information can be stored.

The control unit 7 is a part including a PWM circuit and capable of generating the PWM control signal, and is a part switchable between ON and OFF states of each of the switching elements Q1 to Q5 by transmitting the PWM control signal to each of the switching elements Q1 to Q5.

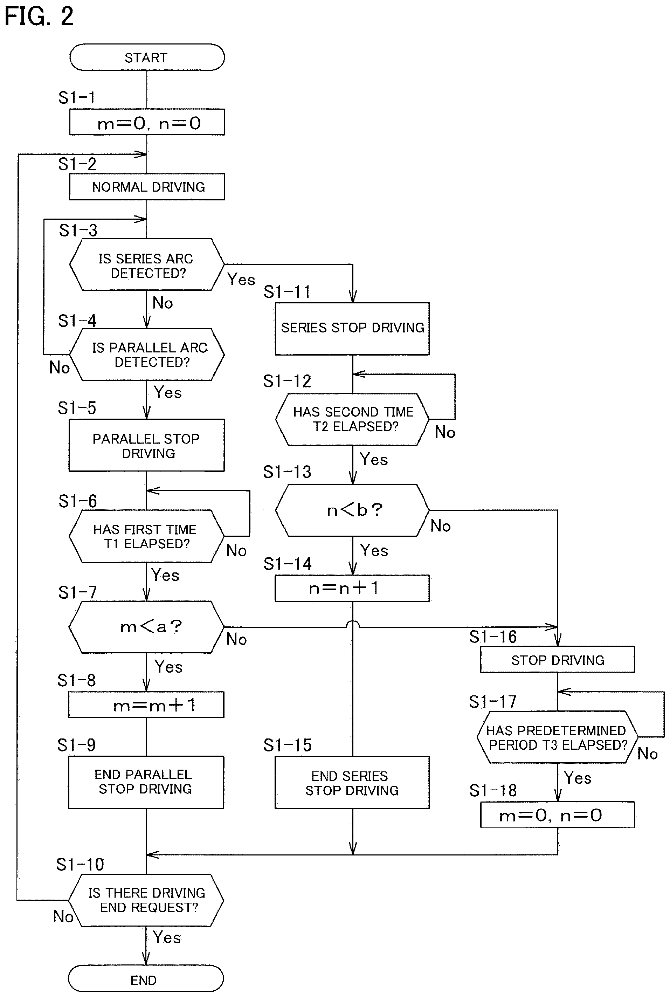

Next, a driving operation of the power supply system 1 will be described with reference to a flowchart of Fig. 2.

The power supply system 1 is designed to extinguish series arc discharge or parallel arc discharge when the series arc discharge or the parallel arc discharge is detected during normal operation.

Specifically, first, as illustrated in Fig. 2, a counter m and a counter n are reset (step S1-1), and the normal operation is performed (step S1-2).

At this time, in the normal operation, the power conversion device 3 performs a power conversion operation (boost operation and transformation operation), wherein by switching periodically between the ON state and the OFF state of the first switching element Q1 of the boost converter portion 10, the input voltage from the power supply module 2 is boosted (transformed), DC power is outputted to the inverter portion 11, and

by switching between the ON state and the OFF state of the switching elements Q2 to Q5 of the inverter portion 11, the DC power inputted from the boost converter portion 10 is converted into AC power.

Subsequently, it is determined whether or not the series arc detector 5 detects series arc discharge (step S1-3), and in a case where series arc discharge is not detected (No in step S1-3), it is determined whether or not the parallel arc detector 6 detects parallel arc discharge (step S1-4).

In a case where the parallel arc detector 6 detects parallel arc discharge (Yes in step S1-4), the normal operation is interrupted, and the parallel stop driving is performed (step S1-5).

At this time, in the parallel stop driving, the power conversion device 3 performs a parallel arc interruption operation in which the first switching element Q1 of the boost converter portion 10 is kept in the ON state or is put into the ON state and then maintained, and the switching elements Q2 and Q4 and/or the switching elements Q3 and Q5 of the inverter portion 11 are kept in the OFF state or are put into the OFF state and then maintained.

In a case where a first time T1 has elapsed since the start of the parallel stop driving (Yes in step S1-6), it is determined whether or not the counter m is less than a threshold value a (step S1-7).

At this time, the first time T1 can be appropriately changed, but for example, is preferably 1 second or more, and more preferably 5 seconds or more. In addition, the first time T1 is preferably 60 seconds or less, and more preferably 20 seconds.

At this time, the threshold value a can be appropriately changed, but for example, is preferably 2 or more, and more preferably 3 or more. In addition, the threshold value a is preferably 10 or less, and more preferably 5 or less.

In a case where the counter m is less than the threshold value a (Yes in step S1-7), the counter m is set to m+1 (step S1-8), and the parallel stop driving is ended (step S1-9).

It is determined whether or not there is an operation end request of the power supply system 1 (step S1-10), and in a case where there is an operation end request, the processing is ended as it is without resuming the normal operation (Yes in step S1-10).

On the other hand, in a case where the series arc detector 5 detects series arc discharge in step S1-3 (Yes in step S1-3), the processing proceeds to step S1-11, the normal operation is interrupted, and series stop driving is performed (step S1-11).

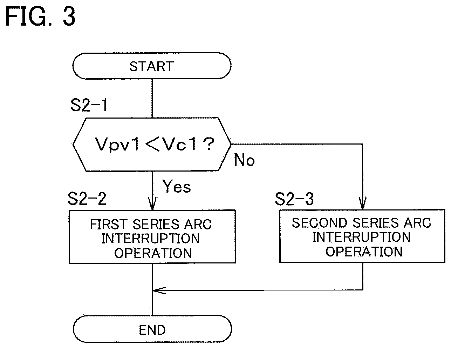

At this time, in the series stop driving, as illustrated in Fig. 3, the power conversion device 3 compares an input voltage Vpv1 (boost-circuit-side voltage) from the power supply module 2 to the boost converter portion 10 with an input voltage Vc1 (inverter-side voltage) from the boost converter portion 10 to the inverter portion 11 (step S2-1). In a case where the input voltage Vpv1 is smaller than the input voltage Vc1 (Yes in step S2-1), the power conversion device 3 performs a first series arc interruption operation in which the first switching element Q1 of the boost converter portion 10 is kept in the OFF state or is put into the OFF state and then maintained (step S2-2).

On the other hand, in a case where the input voltage Vpv1 is equal to or greater than the input voltage Vc1 (No in step S2-1), since there is a possibility that an arc current flows from the boost converter portion 10 to the inverter portion 11, a second series arc interruption operation in which the first switching element Q1 of the boost converter portion 10 is kept in the OFF state or is put into the OFF state and then maintained and the switching elements Q2 and Q3 and/or the switching elements Q4 and Q5 of the inverter portion 11 are kept in the OFF state or are put into the OFF state and then maintained is performed (step S2-3).

In a case where a second time T2 has elapsed since the start of the series stop driving (Yes in step S1-12), it is determined whether or not the counter n is less than a threshold value b (step S1-13).

At this time, the second time T2 can be appropriately changed, but for example, is preferably 1 second or more, and more preferably 5 seconds or more. In addition, the second time T2 is preferably 60 seconds or less, and more preferably 20 seconds.

At this time, the threshold value b can be appropriately changed, but for example, is preferably 2 or more, and more preferably 3 or more. In addition, the threshold value b is preferably 10 or less, and more preferably 5 or less.

In a case where the counter n is less than the threshold value b (Yes in step S1-13), the counter n is set to n+1 (step S1-14), the series stop driving is ended (step S1-15), and the processing proceeds to step S1-10.

On the other hand, in step S1-13, in a case where the counter n is equal to or greater than the threshold value b (No in step S1-13), the processing proceeds to step S1-16, and a driving stop operation in which at least the driving of the power conversion device 3 is stopped and the driving of the power supply system 1 is stopped is performed.

In step S 1-16, in a case where the predetermined period T3 has elapsed since the driving of the power supply system 1 is stopped (since the start of the driving stop operation) (Yes in step S1-17), the counter m and the counter n are reset (step S1-18), and the processing proceeds to step S1-10.

At this time, the predetermined period T3 can be appropriately changed, but for example, is preferably 12 hours or more, and more preferably 1 day or more. In addition, it is preferable that the predetermined period T3 is 7 days or less.

Note that the predetermined period T3 may be a predetermined time point such as a scheduled time on the next day (for example, 12:00).

In step S1-4, in a case where the parallel arc detector 6 does not detect parallel arc discharge (No in step S1-4), the processing proceeds to step S1-3, and the normal operation is continued.

In step S1-7, in a case where the counter m is equal to or greater than the threshold value a (No in step S1-7), the processing proceeds to step S1-16, the driving stop operation in which at least the driving of the power conversion device 3 is stopped and the driving of the power supply system 1 is stopped is performed (step S1-16).

In step S1-10, in a case where there is no operation end request of the power supply system 1 (No in step S1-10), the processing proceeds to step S1-2, and the normal operation is resumed.

With the power supply system 1 of the present embodiment, in a case where the series arc detector 5 detects series arc discharge and, with reference to the diode portion D1 (rectifying portion), the voltage Vpv1 on the boost circuit side is the same as or greater than the voltage Vc1 on the inverter portion 11 side, the first switching element Q1 is put into the OFF state, the power input from the boost converter portion 10 side to the system-side connection terminals 22 and 23 side is interrupted by the switching elements Q2 to Q5 as the interrupter, and the distribution of power flowing between the boost converter portion 10 and the system-side connection terminals 22 and 23 is interrupted, so that the short circuit between the positive electrode side and the negative electrode side of the power supply module 2 can be prevented.

In addition, with the power supply system 1 of the present embodiment, in a case where the series arc detector 5 detects series arc discharge and, with reference to the diode portion D1, the voltage Vpv1 on the boost circuit side is smaller than the voltage Vc1 on the inverter portion 11 side, a current does not flow from the boost circuit side to the inverter portion 11 side by the diode portion D1 as the rectifying portion, and the distribution of power flowing between the boost converter portion 10 and the system-side connection terminals 22 and 23 is interrupted, so that the short circuit between the positive electrode side and the negative electrode side of the power supply module 2 can be prevented.

As described above, with the power supply system 1 of the present embodiment, regardless of the magnitude between the voltage Vpv1 on the boost circuit side and the voltage Vc1 on the inverter portion 11 side with reference to the diode portion D1, it is not necessary to provide a breaker between the power supply module 2 and the power conversion device 3, and it is possible to promptly extinguish the series arc discharge when the series arc discharge occurs without increasing the size of the entire system.

With the power supply system 1 of the present embodiment, when the parallel arc detector 6 detects parallel arc discharge, the first switching element Q1 is put into the ON state to conduct (short circuit) the positive-electrode-side input terminal 20a side and the negative-electrode-side input terminal 20b side, and the positive-electrode-side input terminal 20a side and the negative-electrode-side input terminal 20b side are set to the same potential, so that the parallel arc discharge can be promptly extinguished. As a result, it is possible to cope with both series arc discharge and parallel arc discharge.

With the power supply system 1 of the present embodiment, in the boost converter portion 10, since the capacitor portion C1 is connected in parallel to the first switching element Q1, the output voltage from the boost converter portion 10 to the inverter portion 11 can be smoothed.

With the power supply system 1 of the present embodiment, when the second time T2 has elapsed after the series arc detector 5 detects series arc discharge, the power conversion device 3 resumes the power conversion operation (boost operation, transformation operation). That is, even when the series arc discharge is detected, the arc discharge can be promptly extinguished, and the power conversion operation (boost operation, transformation operation) can be automatically resumed, so that the operating time can be extended as compared with the related art.

With the power supply system 1 of the present embodiment, in a case where the series arc interruption operation is performed a predetermined number of times b or more, the driving stop operation of stopping the driving of the power supply system 1 is performed, so that occurrence of a fire can be prevented and safety is high.

With the power supply system 1 of the present embodiment, when the first time T1 has elapsed after the parallel arc detector 6 detects parallel arc discharge, the power conversion device 3 resumes the power conversion operation (boost operation, transformation operation). That is, even when the parallel arc discharge is detected, the arc discharge can be promptly extinguished, and the power conversion operation (boost operation, transformation operation) can be automatically resumed, so that the operating time can be extended as compared with the related art.

With the power supply system 1 of the present embodiment, in a case where the parallel arc interruption operation is performed a predetermined number of times a or more, the driving of the power supply system 1 is forcibly stopped. That is, since the driving of the power conversion device 3 is forcibly stopped, the occurrence of a fire can be prevented, and safety is high.

With the power supply system 1 of the present embodiment, when the predetermined period T3 has elapsed after the driving stop operation is executed, the driving stop operation is ended, so that the power supply system 1 can be automatically operated again.

With the power supply system 1 of the present embodiment, when the series arc detector 5 detects series arc discharge, the input power from the boost converter portion 10 is interrupted using the full-bridge circuit which is a power conversion circuit of the inverter portion 11. Therefore, it is not necessary to separately provide a breaker in the inverter portion 11, and it is more possible to suppress an increase in size.

Subsequently, a power supply system 201 of a second embodiment of the present invention will be described. Note that the same configurations as those of the power supply system 1 of the first embodiment are denoted by the same reference numerals, and the description thereof will be omitted. The same applies hereinafter.

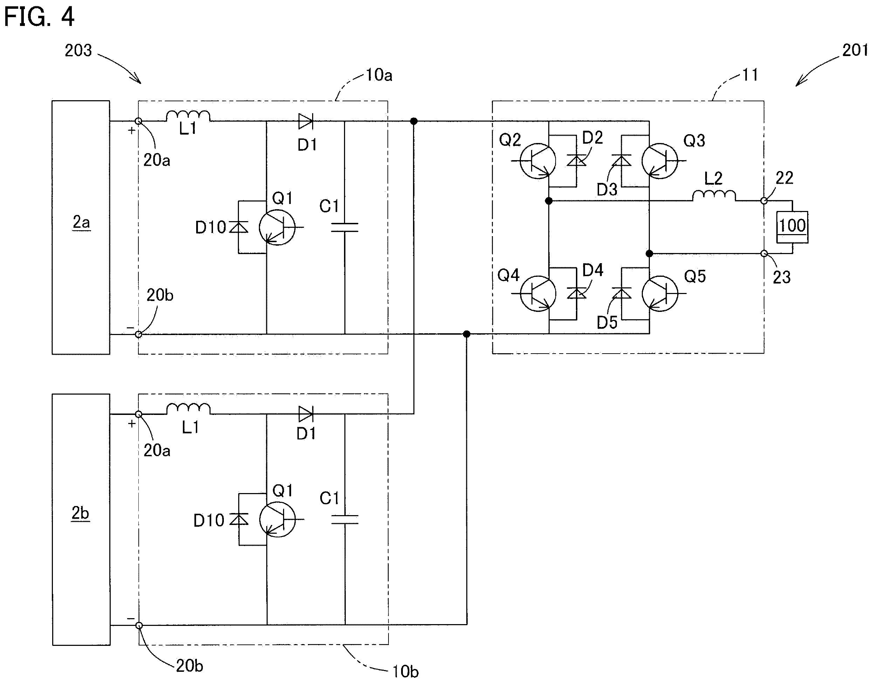

As illustrated in Fig. 4, a power supply system 201 according to a second embodiment includes a plurality of power supply modules 2a and 2b, a power conversion device 203, the series arc detector 5, the parallel arc detector 6, and the control unit 7.

(Power Conversion Device 203)

The power conversion device 203 includes a plurality of boost converter portions 10a and 10b, and the inverter portion 11, and the boost converter portions 10a and 10b are connected in parallel.
The boost converter portions 10a and 10b are individually connected to the power supply modules 2a and 2b, respectively.
Subsequently, a driving operation of the power supply system 201 of the second embodiment will be described.
The driving operation of the power supply system 201 of the second embodiment is different from that of the power supply system 1 of the first embodiment in the parallel stop driving and the series stop driving.
Specifically, in the parallel stop driving of the power supply system 201, in one power supply module 2a that has detected the parallel arc discharge, the first switching element Q1 of the corresponding boost converter portion 10a is kept in the ON state or is put into the ON state and then maintained, and the driving of the remaining power supply module 2b is continued as it is. That is, for the power generated by the remaining power supply module 2b, the boost operation by the boost converter portion 10b and the power conversion operation by the inverter portion 11 are continued.
In addition, in the series stop driving of the power supply system 201, in one power supply module 2a that has detected the series arc discharge, the input voltage Vpv1 from the power supply module 2a to the boost converter portion 10a is compared with the input voltage Vc1 from the boost converter portion 10a to the inverter portion 11, and in a case where the input voltage Vpv1 is smaller than the input voltage Vc1, the first switching element Q1 of the boost converter portion 10a is kept in the OFF state or is put into the OFF state and then maintained, and the driving of the remaining power supply module 2b is continued as it is. That is, for the power generated by the remaining power supply module 2b, the boost operation by the boost converter portion 10b and the power conversion operation by the inverter portion 11 are continued.
On the other hand, in a case where the input voltage Vpv1 is equal to or greater than the input voltage Vc1, while the first switching element Q1 of the boost converter portion 10a is kept in the OFF state or is put into the OFF state and then maintained, the switching elements Q2 to Q5 of the inverter portion 11 are kept in the OFF state or are put into the OFF state and then maintained, the driving of the remaining power supply module 2b is stopped, and the boost operation of the remaining boost converter portion 10b is also stopped.
With the power supply system 201 of the second embodiment, the boost converter portions 10a and 10b are allocated to the plurality of power supply modules 2a and 2b, respectively. In a case where series arc discharge occurs in one power supply module 2a, and in a case where, with reference to the diode portion D1 of the boost converter portion 10a, the voltage Vpv1 on the power supply module 2a side is smaller than the voltage Vc1 on the inverter portion 11 side, the series arc discharge can be extinguished only by putting the first switching element Q1 of the boost converter portion 10a into the OFF state.

That is, since the inverter portion 11 can be operated regardless of the presence or absence of occurrence of the series arc discharge, the driving can be continued in the remaining power supply module 2b and the corresponding boost converter portion 10b even during the series stop driving.

Subsequently, a power supply system 301 of a third embodiment of the present invention will be described.

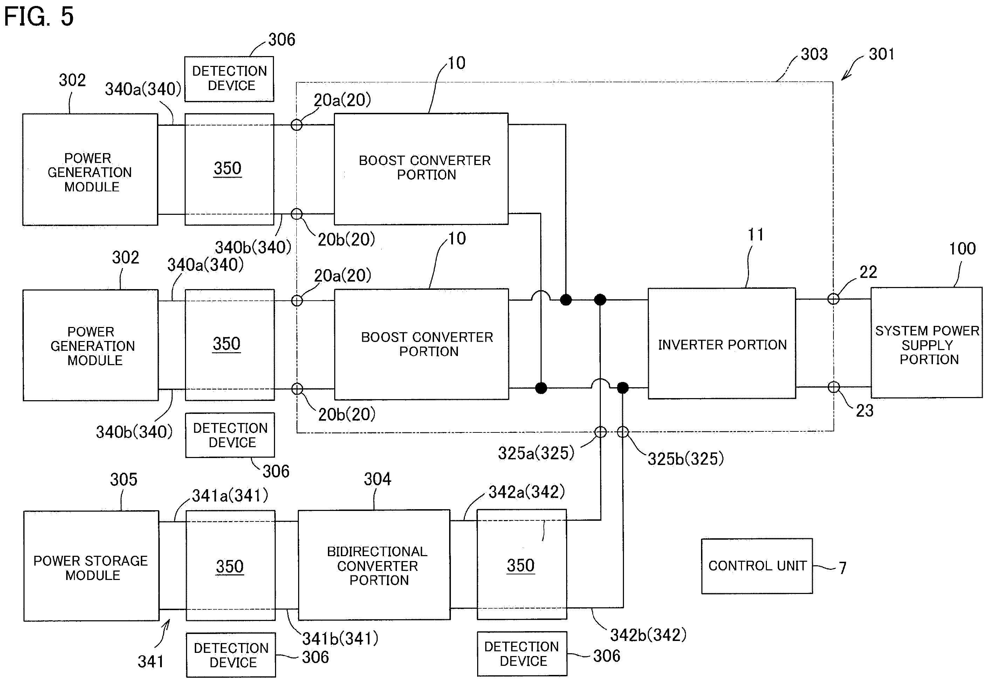

As illustrated in Fig. 5, the power supply system 301 of the present embodiment includes one or a plurality of power generation modules 302, a power conversion device 303, a bidirectional converter portion 304, a power storage module 305, a detection device 306 (arc detection means), and the control unit 7 (arc detection means). Then, in the power supply system 301, the system power supply portion 100 can be connected to the power conversion device 303.

The power supply system 301 can supply the power generated by each power generation module 302 and the power stored in the power storage module 305 to the system power supply portion 100 connected to the power conversion device 303.

(Power Generation Module 302)

The power generation module 302 is a power supply module that supplies power to the system power supply portion 100, and is a power generation module that generates power using renewable energy such as a solar cell module or a fuel cell module.

The power generation module 302 of the present embodiment uses a solar cell module similarly to the power supply module 2 of the first embodiment.

(Power Conversion Device 303)

As illustrated in Fig. 5, the power conversion device 303 includes one or a plurality of boost converter portions 10, the inverter portion 11, the module-side connection terminal 20 (20a, 20b), the system-side connection terminals 22 and 23, and a converter-side connection terminal 325 (325a, 325b).

(Boost converter portion 10)

Each boost converter portion 10 is electrically connected to each power generation module 302 via the module-side connection terminal 20 and a first connection wiring portion 340 (first wiring portion, wiring portion).

The module-side connection terminal 20 includes the positive-electrode-side input terminal 20a and the negative-electrode-side input terminal 20b.

The first connection wiring portion 340 has a first positive-electrode-side wiring portion 340a and a first negative-electrode-side wiring portion 340b.

The first positive-electrode-side wiring portion 340a is a connection wiring line that connects a terminal on the positive electrode side of the power generation module 302 and the positive-electrode-side input terminal 20a.

The first negative-electrode-side wiring portion 340b is a connection wiring line that connects a terminal on the negative electrode side of the power generation module 302 and the negative-electrode-side input terminal 20b.

(Inverter portion 11)

The inverter portion 11 can convert the DC power supplied from the power generation modules 302 side and the DC power supplied from the power storage module 305 side into the AC power, and can convert the AC power supplied from the system power supply portion 100 side into the DC power.

(Bidirectional converter portion 304)

The bidirectional converter portion 304 has a boost circuit and a step-down circuit.

That is, the bidirectional converter portion 304 is a step-down converter that steps down the power supplied from the power conversion device 303 side and supplies the stepped-down power to the power storage module 305, and is also a boost converter that boosts the power supplied from the power storage module 305 and supplies the boosted power to the power conversion device 303 side.

Here, the boost converter portion 10 is connected to the bidirectional converter portion 304 via the converter-side connection terminal 325 and a third connection wiring portion 342 (third wiring portion, wiring portion).

The converter-side connection terminal 325 includes a positive-electrode-side input terminal 325a and a negative-electrode-side input terminal 325b.

The third connection wiring portion 342 has a third positive-electrode-side wiring portion 342a and a third negative-electrode-side wiring portion 342b.

The third positive-electrode-side wiring portion 342a is a connection wiring line that connects a terminal on the positive electrode side of the bidirectional converter portion 304 and the positive-electrode-side input terminal 325a.

The third negative-electrode-side wiring portion 342b is a connection wiring line that connects a terminal on the negative electrode side of the bidirectional converter portion 304 and the negative-electrode-side input terminal 325b.

(Power Storage Module 305)

The power storage module 305 is a storage battery including one or a plurality of secondary batteries, and can be charged with power generated by the power generation module 302 or power supplied from the system power supply portion 100, and can discharge the charged power to the system power supply portion 100.

As shown in Fig. 5, the power storage module 305 is electrically connected to the bidirectional converter portion 304 via a second connection wiring portion 341(second wiring portion, wiring portion).

The second connection wiring portion 341 has a second positive-electrode-side wiring portion 341a and a second negative-electrode-side wiring portion 341b.

The second positive-electrode-side wiring portion 341a is a connection wiring line that connects a terminal on the positive electrode side of the power storage module 305 and a terminal on the positive electrode side of the bidirectional converter portion 304.

The second negative-electrode-side wiring portion 341b is a connection wiring line that connects a terminal on the negative electrode side of the power storage module 305 and a terminal on the negative electrode side of the bidirectional converter portion 304.

(Detection Device 306)

The detection device 306 is a coil type sensor (ring coil sensor) having a detection coil, and is a device capable of measuring (detecting) high-frequency noise associated with the occurrence of arc discharge in a target wiring line in a state of not being in contact with the wiring line.

In the power supply system 301 of the present embodiment, as illustrated in Fig. 5, each of the first connection wiring portion 340, the second connection wiring portion 341, and the third connection wiring portion 342 is a wiring line (wiring line as a measurement target) to be a target of the detection device 306, and individual detection devices 306 are arranged at positions in the vicinity of each of the wiring portions 340 to 342 and not in contact with each of the wiring portions 340 to 342.

That is, in the power supply system 301, the detection device 306 is provided individually corresponding to the first connection wiring portion 340, the second connection wiring portion 341, and the third connection wiring portion 342.

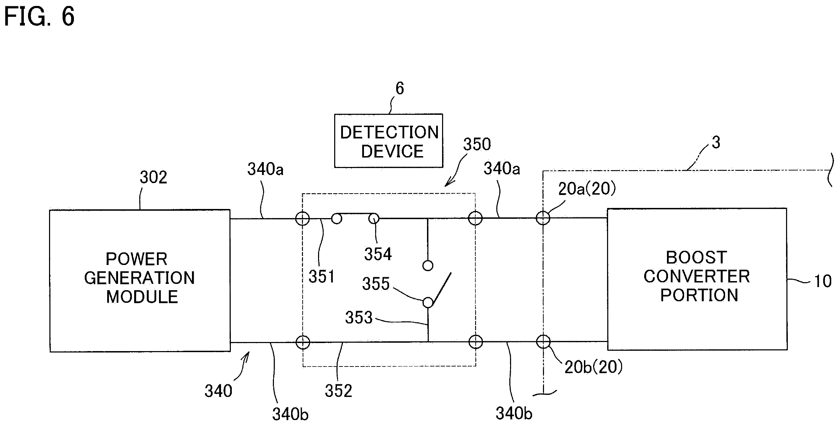

In the power supply system 301 of the present embodiment, as illustrated in Figs. 5 and 6, an interruption device 350 is provided in an intermediate portion of each of the first connection wiring portion 340, the second connection wiring portion 341, and the third connection wiring portion 342.

Note that in the following description, the interruption device 350 provided in the intermediate portion of the first connection wiring portion 340 will be described in detail, and the interruption device 350 provided in the intermediate portion of each of the second connection wiring portion 341 and the third connection wiring portion 342 is similar, and thus the detailed description thereof will be omitted.

As illustrated in Fig. 6, the interruption device 350 includes a positive electrode wiring portion 351, a negative electrode wiring portion 352, a short-circuit wiring portion 353, a first relay portion 354 (series arc interrupter), and a second relay portion 355 (parallel arc short-circuit portion).

The positive electrode wiring portion 351 is positioned in an intermediate portion of the first positive-electrode-side wiring portion 340a.

Specifically, the positive electrode wiring portion 351 is positioned between a portion on the power generation module 302 side of the first positive-electrode-side wiring portion 340a and a portion on the boost converter portion 10 (power conversion device 303) side of the first positive-electrode-side wiring portion 340a, and electrically connects the portions.

That is, the positive electrode wiring portion 351 constitutes a part of the first positive-electrode-side wiring portion 340a, and specifically forms an intermediate portion of the first positive-electrode-side wiring portion 340a.

The negative electrode wiring portion 352 is positioned in an intermediate portion of the first negative-electrode-side wiring portion 340b.

Specifically, the negative electrode wiring portion 352 is positioned between a portion on the power generation module 302 side of the first negative-electrode-side wiring portion 340b and a portion on the boost converter portion 10 (power conversion device 303) side of the first negative-electrode-side wiring portion 340b, and electrically connects the portions.

That is, the negative electrode wiring portion 352 constitutes a part of the first negative-electrode-side wiring portion 340b, and specifically forms an intermediate portion of the first negative-electrode-side wiring portion 340b.

The short-circuit wiring portion 353 is a connection wiring line that connects the positive electrode wiring portion 351 and the negative electrode wiring portion 352, and is a part that makes the positive electrode wiring portion 351 and the negative electrode wiring portion 352 conductive.

The first relay portion 354 is a relay that is provided in the middle of the positive electrode wiring portion 351 and automatically opens and closes the switch, and is a part that switches a conduction state and an interruption state of power between the power generation module 302 side and the boost converter portion 10 (power conversion device 303) side by switching on and off.

The first relay portion 354 is in a closed state in a normal state in which no arc discharge occurs, and the power generation module 302 side and the boost converter portion 10 side are in a conduction state.

The second relay portion 355 is a relay that is provided in the middle of the short-circuit wiring portion 353 and automatically opens and closes the switch, and is a part that switches a conduction state and an interruption state of power between the positive electrode wiring portion 351 side and the negative electrode wiring portion 352 side by switching on and off.

The second relay portion 355 is in an open state in a normal state in which no arc discharge occurs, and the positive electrode wiring portion 351 side and the negative electrode wiring portion 352 side are in an open state (interruption state).

Subsequently, a risk degree determination operation executed by the power supply system 301 of the present embodiment will be described in detail.

The risk degree determination operation is an operation of discriminating whether or not arc discharge occurs in a predetermined wiring line, and discriminating whether or not the arc discharge that has occurred is significant (large-scale) enough to lead to a fire or the like in a case where it is discriminated that the arc discharge has occurred.

In the risk degree determination operation of the present embodiment, the first connection wiring portion 340, the second connection wiring portion 341, and the third connection wiring portion 342 are set as target wiring lines (wiring portions), and it is discriminated whether or not arc discharge occurs in the wiring lines, and whether or not the arc discharge that has occurred is a significant enough to lead to a fire or the like.

In the following description, the risk degree determination operation for the first connection wiring portion 340 will be described in detail.

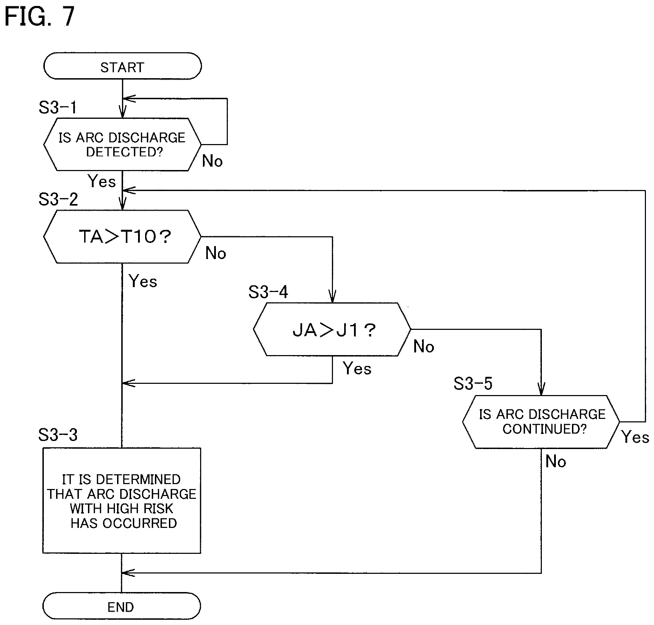

First, prior to the risk degree determination operation, a time setpoint T10 (first threshold value), a voltage setpoint V1, a current setpoint I1, and a work amount reference value J1 (second threshold value) illustrated in Fig. 7 are set.

The time setpoint T10 is a value set based on data of an accident caused by arc discharge occurring in another solar power generation system or the like in the past and knowledge based on experience of the manager.

The time setpoint T10 is preferably a value of more than 0 seconds and less than 2.5 seconds, and more preferably a value of 1.5 seconds or more.

The time setpoint T10 of the present embodiment is 2.4 seconds.

The voltage setpoint V1 is a value set based on data of an accident caused by arc discharge occurring in another solar power generation system or the like in the past and knowledge based on experience of the manager. That is, the voltage setpoint V1 is the magnitude of the discharge potential predicted in a case where arc discharge occurs.

The voltage setpoint V1 is preferably a value of 0 V or more and less than 50 V, and more preferably a value of 30 V or more.

The voltage setpoint V1 of the present embodiment is 40 V.

The current setpoint I1 is a value set according to an output current value of the power generation module 302 to which the first connection wiring portion 340 is connected, and in the present embodiment, a value of the maximum output operating current (Ipm) of the power generation module 302 is set as the current setpoint I1.

That is, the current setpoint I1 is a value that is increased or decreased according to the output current value of the power generation module 302 adopted in the power supply system 301.

Therefore, in a case where the output current value (the value of the maximum output operating current) of the adopted power generation module 302 is small, the current setpoint I1 is also small, and in a case where the output current value of the adopted power generation module 302 is large, the current setpoint I1 is also large.

Note that in the present embodiment, the current setpoint I1 is set to substantially the same value as the maximum output operating current of power generation module 302. However, the "substantially the same value" mentioned herein is not limited to the exactly same value, and allows an error of several percent, and for example, the difference between the two is acceptable if it is no more than 5%.

In addition, the current setpoint I1 may be set to substantially the same value as the maximum output operating current of the power generation module 302, or may be set to a short-circuit current value (Isc) of the power generation module 302.

The work amount reference value J1 is a value set based on data of an accident caused by arc discharge occurring in another solar power generation system or the like in the past and knowledge based on experience of the manager, and is a threshold value serving as a reference of the magnitude of the arc discharge.

The work amount reference value J1 is preferably a value exceeding 0 J (joule) and 850 J (joule) or less, and more preferably a value of 500 J or more and 750 J or less.

The work amount reference value J1 of the present embodiment is 750 J.

The time setpoint T10, the voltage setpoint V1, the current setpoint I1, and the work amount reference value J1 may be set by a worker inputting values using information input means such as a keyboard. In addition, the worker may perform the setting by selecting one value from among candidate values (values as candidates) of the values displayed in a list.

In this manner, in addition to the setting by the input work of the worker, the setting may be automatically performed by information received from an external computer.

That is, a signal (information indicating a value) may be received from an external server, and setting may be automatically executed based on the received signal (information indicating a value).

In the power supply system 301 of the present embodiment, when the operation is started, a detection (measurement) operation is executed by the detection device 306.

Specifically, the detection device 306 constantly monitors whether or not high-frequency noise associated with the occurrence of arc discharge occurs in the first connection wiring portion 340 (hereinafter, also simply referred to as high-frequency noise). Then, when the occurrence of the high-frequency noise is detected, the detection device 306 acquires an occurrence time (duration) of the high-frequency noise.

That is, the detection device 306 updates the occurrence time (duration) every lapse of a predetermined time from a reference time point at which the occurrence of the high-frequency noise is detected. In other words, the detection device 306 detects the presence or absence of the high-frequency noise at predetermined intervals from the time point at which the high-frequency noise is detected for the first time, and updates the occurrence time as the duration every time the high-frequency noise is detected.

For example, when 0.5 seconds have elapsed from the time point at which the occurrence of high-frequency noise is detected, the occurrence time (duration) is 0.5 seconds, and when 1 second has elapsed, the occurrence time (duration) is 1 second.

The power supply system 301 of the present embodiment discriminates that arc discharge has occurred in a case where the occurrence of the high-frequency noise is detected. Then, the occurrence time (duration) of the high-frequency noise is acquired as an occurrence time TA (duration TA) of the arc discharge. That is, the detection device 306 and the control unit 7 function as arc detection means.

In the power supply system 301 of the present embodiment, as illustrated in Fig. 7, in a case where the occurrence of the high-frequency noise is not detected by the detection device 306 (case of No in step S3-1), it is continuously discriminated whether or not the high-frequency noise occurs.

Then, in a case where the occurrence of the high-frequency noise is detected by the detection device 306 (case of Yes in step S3-1), the occurrence time of the high-frequency noise, which is the duration of the high-frequency noise from the occurrence time point of the high-frequency noise, is acquired as the occurrence time TA (duration TA) of the arc discharge, and the occurrence time TA of the arc discharge is compared with the time setpoint T10 (step S3-2).

In a case where the occurrence time TA (duration TA) of the arc discharge exceeds the time setpoint T10 (case of Yes in step S3-2, case of reaching a first criteria), it is discriminated that the arc discharge with a high risk has occurred (step S3-3).

On the other hand, in a case where the occurrence time TA (duration TA) of the arc discharge is equal to or less than the time setpoint T10 (case of No in step S3-2), an occurrence discharge work amount JA (risk discrimination work amount) is calculated by the following Equation (1), and the occurrence discharge work amount JA is compared with the work amount reference value J1 (step S3-4).

$$JA = I1*V1*TA \cdots (1)$$

In a case where the occurrence discharge work amount JA exceeds the work amount reference value J1 (case of Yes in step S3-4, case of reaching a second criteria), the processing proceeds to step S3-3, and it is discriminated that the arc discharge with a high risk has occurred.

On the other hand, in a case where the occurrence discharge work amount JA is equal to or less than the work amount reference value J1 (case of No in step S3-4), it is checked whether or not the arc discharge is continued (step S3-5), and in a case where the high-frequency noise is detected and the arc discharge is not continued (No in step S3-5), it is discriminated that the risk of the arc discharge that has occurred is low.

That is, in the present embodiment, in a case where the occurrence time TA of the arc discharge is equal to or less than the time setpoint T10 and the occurrence discharge work amount JA is equal to or less than the work amount reference value J1, it is discriminated that the risk of the arc discharge that has occurred is low.

On the other hand, in step S3-5, in a case where the high-frequency noise is detected and the arc discharge is continued (Yes in step S3-5), the occurrence time TA (duration TA) is updated, and the processing proceeds to step S3-2.

The power supply system 301 of the present embodiment has the interruption device 350 (refer to Fig. 6) as described above, and executes the arc interruption operation in a case where it is discriminated that the arc discharge with a high risk has occurred (step S3-3). The arc discharge interruption operation is an operation of extinguishing arc discharge with a high risk that has occurred.

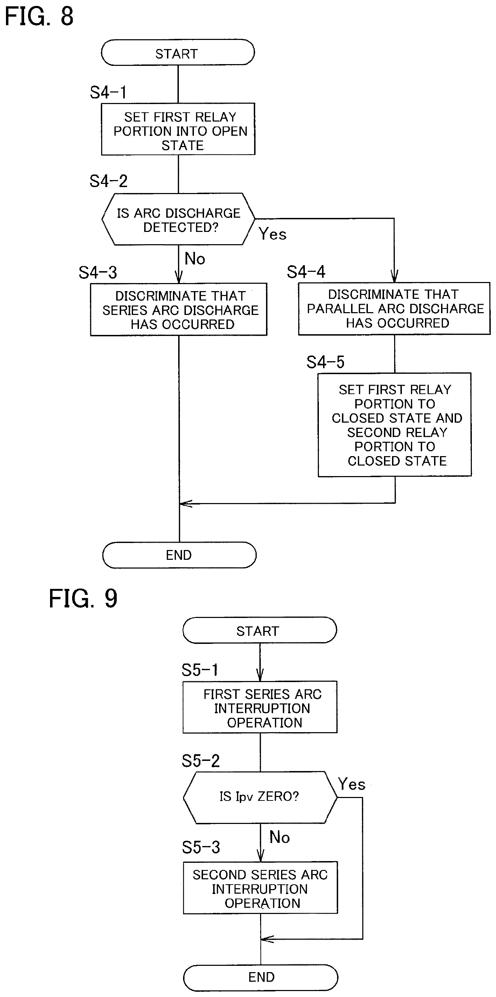

In the arc interruption operation, first, as illustrated in Fig. 8, the first relay portion 354 is put into the open state to interrupt the conduction of power between the power generation module 302 side and the boost converter portion 10 side (step S4-1).

In addition, before and after this, the presence or absence of the occurrence of high-frequency noise is detected by the detection device 306.

Specifically, after the first relay portion 354 is put into the open state, in a case where the high-frequency noise (arc discharge) is not continuously detected by the detection device 306 (No in step S4-2), it is discriminated that the arc discharge that has occurred is series arc discharge and the arc discharge is extinguished (step S4-3).

On the other hand, even when the first relay portion 354 is put into the open state in step S4-1, in a case where the high-frequency noise (arc discharge) is continuously detected by the detection device 306 (Yes in step S4-2), it is discriminated that the arc discharge that has occurred is parallel arc discharge and the arc discharge is not yet extinguished (step S4-4).

Then, in a case where it is discriminated in step S4-4 that the arc discharge that has occurred is the parallel arc discharge (case where the high-frequency noise is continuously detected), the first relay portion 354 is shifted from the open state to the closed state, and the second relay portion 355 is put into the closed state (step S4-5).

That is, the first relay portion 354 is put into the closed state to enable the conduction of power between the power generation module 302 side and the boost converter portion 10 side, and the second relay portion 355 is put into the closed state to short-circuit the positive electrode wiring portion 351 and the negative electrode wiring portion 352. As a result, the arc discharge is extinguished.

Since the risk degree determination operation and the interruption operation for the second connection wiring portion 341 and the third connection wiring portion 342 are substantially the same as those for the first connection wiring portion 340, detailed description thereof will be omitted.

Note that in a case where the second connection wiring portion 341 is the target, the current setpoint I1 is a value set according to the output current value of the power storage module 305. In addition, in a case where the third connection wiring portion 342 is the target, the current setpoint I1 is a value set based on data of an accident caused by arc discharge occurring in another solar power generation system or the like in the past and knowledge based on experience of the manager.

With the power supply system 301 of the third embodiment, each detection device 306 can acquire the presence or absence of the occurrence of arc discharge and the occurrence time (duration of the arc discharge) when the arc discharge occurs in the first connection wiring portion 340, the second connection wiring portion 341, and the third connection wiring portion 342, which are the targets, in a state of not being in contact with the first connection wiring portion 340, the second connection wiring portion 341, and the third connection wiring portion 342, which are the targets, and it is easy to retrofit the arc detection means.

With the power supply system 301 of the third embodiment, since it is possible to discriminate, with a simple configuration, whether or not the arc discharge that has occurred has a high risk (large-scale) enough to lead to a fire, it is possible to appropriately deal with arc discharge that has occurred.

With the power supply system 301 of the third embodiment, as a result of comparing the occurrence time TA(duration TA) of the arc discharge with the time setpoint T10, in a case where the occurrence time TA (duration TA) of the arc discharge that has occurred is equal to or less than the time setpoint T10 (in case of discriminating that the first reference is not reached), the occurrence discharge work amount JA (risk discrimination work amount) is compared with the preset work amount reference value J1, and it is discriminated whether or not the arc discharge that has occurred reaches the second criteria as a criteria for risk assessment, based on a result of comparison. Therefore, the risk of the arc discharge that has occurred can be more accurately discriminated.

With the power supply system 301 of the third embodiment, the arc interruption operation is performed in a case where the occurrence time TA (duration TA) of the arc discharge that has occurred exceeds the time setpoint T10 or in a case where the occurrence discharge work amount JA exceeds the work amount reference value J1. In the arc interruption operation, the conduction of power between the power generation module 302 and the power conversion device 303 is interrupted by the first relay portion 354, and in a case where the arc discharge continuously occurs after the interruption, the interruption by the first relay portion 354 is released, and the positive electrode wiring portion 351 and the negative electrode wiring portion 352 are made conductive by the second relay portion 355. Therefore, even in a case where the arc discharge that has occurred is either series arc or parallel arc, the arc discharge can be appropriately extinguished by the arc interruption operation.

With the power supply system 301 of the third embodiment, the current setpoint I1, the voltage setpoint V1, and the work amount reference value J1 are set based on information input by information input means that receives an input of information from a user or information transmitted from an external device. Therefore, appropriate setting can be made for each of various power supply systems, and the risk of arc discharge can be accurately discriminated in various power supply systems.

In the first embodiment and the second embodiment described above, in the series stop driving, the interruption operations of the first series arc interruption operation and the second series arc interruption operation are determined depending on the difference between the voltage Vpv1 on the power supply module 2 side and the voltage Vc1 on the inverter portion 11 side with reference to the diode portion D1, but the present invention is not limited thereto. The first series arc interruption operation and the second series arc interruption operation may be performed in order.

Specifically, in the series stop driving, as illustrated in Fig. 9, the first series arc interruption operation in which the first switching element Q1 of the boost converter portion 10 in kept in the OFF state or is put into the OFF state and then maintained is executed (step S5-1), and it is determined whether or not a current value Ipv of the power supply module 2 is zero (step S5-2).

In a case where the current value Ipv of the power supply module 2 is not zero (No in step S5-2), the second series arc interruption operation in which the first switching element Q1 of the boost converter portion 10 is kept in the OFF state and the switching elements Q2 to Q5 of the inverter portion 11 are kept in the OFF state or are put into the OFF state and then maintained is executed (step S5-3).

On the other hand, in a case where the current value Ipv of the power supply module 2 is zero (Yes in step S5-2), the first series arc interruption operation is continued as it is.

In the first embodiment and the second embodiment described above, the parallel stop driving is ended on condition that the first time T1 elapses since the start of the parallel stop driving, but the present invention is not limited thereto. The parallel stop driving may be ended on condition that the parallel arc detector 6 no longer detects parallel arc discharge.

In the first embodiment and the second embodiment described above, the series stop driving is ended on condition that the second time T2 elapses since the start of the series stop driving, but the present invention is not limited thereto. The series stop driving may be ended on condition that the series arc detector 5 no longer detects series arc discharge.

In the second embodiment described above, the power supply modules 2a and 2b are both solar cell modules, but the present invention is not limited thereto. The power supply modules 2a and 2b may be different types of power supply modules. For example, the power supply module 2a may be a solar cell module, and the power supply module 2b may be a fuel cell module.

Similarly, in the third embodiment described above, each of the power generation modules 302 is a solar cell module, but the present invention is not limited thereto. The power generation modules 302 may be different types of power generation modules.

In the second embodiment described above, the case where the power supply system 201 includes two power supply modules 2a and 2b has been described, but the present invention is not limited thereto. The power supply system 201 may include three or more power supply modules 2. In that case, it is preferable to provide the boost converter portion 10 corresponding to each power supply module 2.

Similarly, in the third embodiments described above, the case where the power supply system 301 includes two power generation modules 302 has been described, but the present invention is not limited thereto. The power supply system 301 may include one power generation module 302 or may include three or more power generation modules 302.

In the first embodiment and the second embodiment described above, in the first series arc interruption operation, the input of power to the inverter portion 11 is interrupted by the diode portion D1, and thus the switching elements Q2 to Q5 of the inverter portion 11 are not controlled, but the present invention is not limited thereto. Similarly to the second series arc interruption operation, the switching elements Q2 to Q5 of the inverter portion 11 may be kept in the OFF state or may be put into the OFF state and then maintained.

In the first embodiment and the second embodiment described above, when the parallel arc interruption operation and the second series arc interruption operation are executed, all of the each switching elements Q2 to Q5 are put into the OFF state, but the present invention is not limited thereto. It is sufficient to interrupt the distribution of power flowing between the boost converter portion 10 and the system-side connection terminals 22 and 23, and thus the distribution of power flowing between the boost converter portion 10 and the system-side connection terminals 22 and 23 (connection terminals) may be interrupted also by putting the combination of the second switching element Q2 and the third switching element Q3 connected to the positive electrode side of the power supply module 2 and/or the combination of the fourth switching element Q4 and the fifth switching element Q5 connected to the negative electrode side of the power supply module 2 into the OFF state.

In addition, the distribution of power flowing between the boost converter portion 10 side and the system-side connection terminals 22 and 23 (connection terminals) may be interrupted by providing a relay circuit between each arm of the full-bridge circuit described above including the switching elements Q2 to Q5 and the system-side connection terminals 22 and 23.

In the first embodiment and the second embodiment described above, in a case where the parallel arc detector 6 detects parallel arc discharge, the parallel arc interruption operation is performed, and the first switching element Q1 is put into the ON state, and thus the positive-electrode-side input terminal 20a side and the negative-electrode-side input terminal 20b side are conducted via the first switching element Q1 to extinguish the parallel arc discharge, but the present invention is not limited thereto.

For example, in a case where a relay circuit is provided between each arm of the full-bridge circuit including the switching elements Q2 to Q5 and the system-side connection terminals 22 and 23 and the parallel arc detector 6 detects parallel arc discharge, while the distribution of power flowing between the boost converter portion 10 side and the system-side connection terminals 22 and 23 (connection terminals) may be interrupted by the relay circuit, the combination of the second switching element Q2 and the fourth switching element Q4 and/or the combination of the third switching element Q3 and the fifth switching element Q5 may be put into the ON state, and thus the positive-electrode-side input terminal 20a side and the negative-electrode-side input terminal 20b side may be conducted via the switching elements Q2 and Q4 and/or the switching elements Q3 and Q5 in the ON state to extinguish the parallel arc discharge. In this case, the first switching element Q1 may be in the ON state or in the OFF state.

In the embodiment described above, the inverter portion 11 converts the DC power into the AC power by the full-bridge circuit, but the present invention is not limited thereto. The inverter portion 11 may convert the DC power into the AC power by a half-bridge circuit.

In the embodiment described above, one control unit 7 performs PWM control on each of the switching elements Q1 to Q5, but the present invention is not limited thereto. A plurality of control units 7 may perform PWM control on each of the switching elements Q1 to Q5 individually or in each group.

In the embodiment described above, the series arc detector 5 and the parallel arc detector 6 are separate components, but the present invention is not limited thereto. The series arc detector 5 and the parallel arc detector 6 may be integrated.

In the embodiment described above, the converter portion 10 is the boost converter that includes the boost circuit as the converter circuit and boosts the voltage, but the present invention is not limited thereto. The converter portion 10 may be a step-down converter that includes a step-down circuit as the converter circuit and steps down the voltage.

In the embodiment described above, an example in which the interruption device 350 is provided has been described, but the interruption device 350 may not necessarily be provided. For example, in a case where it is discriminated that arc discharge with a high risk has occurred, a notification operation of transmitting a signal indicating the occurrence of arc discharge to external computers or terminals used by the worker or the like and notifying the occurrence of arc discharge through the devices may be executed.

In addition, the interruption device 350 is not necessarily provided outside the power conversion device 303, and for example, it is conceivable to provide the interruption device 350 inside the power conversion device 303 by modifying the power conversion device 303. However, from the viewpoint of facilitating retrofitting, it is preferable to provide the interruption device 350 outside the power conversion device 303.

The power supply system 301 of the embodiment described above includes the bidirectional converter portion 304 and the power storage module 305, but the bidirectional converter portion 304 and the power storage module 305 are not necessarily required, and thus may not be included. In this case, the second connection wiring portion 341 and the third connection wiring portion 342 may not be provided, and the first connection wiring portion 340 may be used as the target wiring portion.

The power supply system 301 of the third embodiment described above can be easily retrofitted with the detection device 306 and the interruption device 350, and can be easily constructed on the basis of an existing power supply system.

Here, existing power supply systems installed in various places employ various power generation modules having different outputs. The risk degree determination operation of the embodiment described above can be executed by various power supply systems only by appropriately changing the current setpoint I1 according to the output of the power generation module 302. That is, it is easy to perform retrofitting for each of the power supply systems constructed on the basis of various existing power supply systems. In other words, the risk degree determination operation of the embodiment described above has high versatility for retrofitting.

In the third embodiment described above, the arc interruption operation is performed using the interruption device 350 to interrupt the arc discharge, but the present invention is not limited thereto. As in the first embodiment, the arc discharge may be interrupted by using the power conversion device 303. For example, after the first series arc interruption operation or the second series arc interruption operation of the first embodiment is performed, whether or not the high-frequency noise is continuously detected may be checked, and in a case where the high-frequency noise is continuously detected, the parallel arc interruption operation may be performed.

In the embodiments described above, each component member can be freely replaced or added between the embodiments as long as it is included in the technical scope of the present invention.

EXPLANATION OF REFERENCE SIGNS

1, 201, 301: power supply system
2: power supply module
3, 203, 303: power conversion device
5: series arc detector
6: parallel arc detector
7: control unit (arc detection means)
10: boost converter portion (converter portion)
11: inverter portion
22, 23: system-side connection terminal
100: system power supply portion
302: power generation module
304: bidirectional converter portion
305: power storage module
306: detection device (arc detection means)
340: first connection wiring portion (first wiring portion, wiring portion)
341: second connection wiring portion (second wiring portion, wiring portion)
342: third connection wiring portion (third wiring portion, wiring portion)
351: positive electrode wiring portion

352: negative electrode wiring portion
354: first relay portion (series arc interrupter)
355: second relay portion (parallel arc short-circuit portion)
C1: capacitor portion
D1: diode portion (rectifying portion)
L1, L2: reactor portion
Q1: switching element
Q2 to Q5: switching element (interrupter)

**Claims**

1. A power supply system comprising:

    a power supply module;
    a power conversion device; and
    a series arc detector,
    wherein the power conversion device includes a converter portion, an inverter portion, and a connection terminal electrically connectable to a system power supply portion,
    the converter portion includes a converter circuit in which a reactor portion and a first switching element are connected in series, and is capable of executing a transformation operation in which an input voltage from the power supply module is boosted or stepped down by switching the first switching element an ON state or an OFF state and power is outputted to the inverter portion,
    the converter portion includes a rectifying portion that allows a flow of a current from the converter circuit side to the inverter portion side and interrupts a flow of a current from the inverter portion side to the converter circuit side,
    the inverter portion includes an interrupter capable of interrupting a supply of power to the connection terminal side of the inverter portion,
    the series arc detector is capable of detecting series arc discharge in a portion closer to the power supply module than to the power conversion device, and
    when the series arc detector detects series arc discharge,
    the transformation operation is stopped, and a series arc interruption operation is executed,
    wherein the series arc interruption operation keeps the first switching element in the OFF state or put it into the OFF state and then maintains and
    interrupts distribution of power flowing between the converter portion and the connection terminal by the interrupter or the rectifying portion.

2. The power supply system according to claim 1,

    wherein the converter portion is a boost converter portion,

    the converter circuit is a boost circuit,
    the boost converter portion is capable of executing a boost operation of

        boosting an input voltage from the power supply module by switching between the ON state and the OFF state of the first switching element and
        outputting power to the inverter portion, and

    the series arc interruption operation,

        when the series arc detector detects series arc discharge,
        stops the boost operation, keeps the first switching element in the OFF state or puts it into the OFF state and then maintains, and interrupts the distribution of power flowing between the boost converter portion and the connection terminal by the interrupter or the rectifying portion.

3. The power supply system according to claim 2, further comprising:

    a parallel arc detector that detects parallel arc discharge in a portion closer to the power supply module than to the power conversion device,
    wherein when the parallel arc detector detects parallel arc discharge, the boost operation is stopped, and a parallel arc interruption operation in which the first switching element is kept in the ON state or is put into the ON state and then maintained is executed.

4. The power supply system according to claim 2 or 3, wherein when a predetermined time elapses after the series arc detector detects the series arc discharge, the boost operation is resumed.

5. The power supply system according to claim 4, wherein in a case where the series arc interruption operation is performed a predetermined number of times or more, a driving stop operation in which driving of the power conversion device is stopped is executed.

6. The power supply system according to claim 3, wherein when a predetermined time elapses after the parallel arc detector detects the parallel arc discharge, the boost operation is resumed.

7. The power supply system according to claim 6, wherein in a case where the parallel arc interruption operation is performed a predetermined number of times or more, a driving stop operation in which driving of the power conversion device is stopped is executed.

8. The power supply system according to claim 5 or 7, wherein when a predetermined period elapses after the driving stop operation is executed, the driving stop operation is ended.

9. The power supply system according to any one of claims 2 to 8,

   wherein the inverter portion includes a second switching element, a third switching element, a fourth switching element, and a fifth switching element,
   the inverter portion includes a full-bridge circuit in which the second switching element and the fifth switching element, and the third switching element and the fourth switching element are respectively arranged diagonally, and
   when the series arc detector detects the series arc discharge, at least one combination of a combination of the second switching element and the third switching element and a combination of the fourth switching element and the fifth switching element is put into the OFF state to interrupt the distribution of power flowing between the boost converter portion and the connection terminal.

10. The power supply system according to claim 2, further comprising:

    a plurality of power supply modules,
    wherein the power conversion device includes a plurality of boost converter portions,
    the plurality of boost converter portions are electrically connected to the plurality of power supply modules, respectively,
    the series arc detector is capable of detecting series arc discharge in a portion closer to each power supply module than to the power conversion device, and
    in a case where the series arc detector detects series arc discharge in a portion on one power supply module side and
    a voltage on the boost circuit side in the boost converter portion corresponding to the one power supply module, with reference to the rectifying portion, is smaller than a voltage on the inverter portion side,
    in the boost converter portion corresponding to the one power supply module,
    the boost operation is stopped and the first switching element is kept in the OFF state or is put into the OFF state and then maintained, and
    in the boost converter portions corresponding to the other power supply modules,
    the boost operation is continued.

11. The power supply system according to any one of claims 1 to 10, further comprising:

    a power supply module;
    a power conversion device;
    a first wiring portion that electrically connects the power supply module and the power conversion device; and
    arc detection means,
    wherein the arc detection means is capable of detecting arc discharge in the first wiring portion in a state of not being in contact with the first wiring portion, and
    in a case where the arc detection means detects arc discharge,
    a risk degree determination operation is executed, in the risk degree determination operation,
    duration of the arc discharge after the arc discharge detection is compared with a first threshold value, and
    whether or not the arc discharge that has occurred reaches a first criteria for risk assessment is discriminated based on a result of the comparison with the first threshold value.

12. The power supply system according to claim 11,

    in a case where it is not discriminated that the arc discharge that has occurred reaches the first criteria as a result of comparing the duration with the first threshold value,

    the risk degree determination operation compares a risk discrimination work amount with a preset second threshold value, and discriminates whether or not the arc discharge that has occurred reaches a second criteria for risk assessment based on a result of comparison with the second threshold value, and

    the risk discrimination work amount is calculated based on a current setpoint according to an output of the power supply module, a voltage setpoint based on a voltage at a time of occurrence of the arc discharge, and the duration.

13. The power supply system according to claim 12, wherein the current setpoint, the voltage setpoint, and the second threshold value are set based on information input by information input means that receives an input of information from a user, or information transmitted from an external device.

14. A power supply system comprising:

    a power supply module;

a power conversion device;
a first wiring portion that electrically connects the power supply module and the power conversion device; and
arc detection means,
wherein the arc detection means is capable of detecting arc discharge in the first wiring portion in a state of not being in contact with the first wiring portion, and
in a case where the arc detection means detects arc discharge,
a risk degree determination operation is executed,
in the risk degree determination operation,
duration of the arc discharge after the arc discharge detection is compared with a first threshold value, and
whether or not the arc discharge that has occurred reaches a first criteria for risk assessment is discriminated based on a result of the comparison with the first threshold value.

15. A power supply system comprising:

a power generation module;
a power conversion device;
a power storage module;
a bidirectional converter portion; and
arc detection means,
wherein a first wiring portion that electrically connects the power generation module and the power conversion device, a second wiring portion that electrically connects the power storage module and the bidirectional converter portion, and a third wiring portion that electrically connects the bidirectional converter portion and the power conversion device are provided,
the arc detection means is capable of detecting arc discharge in at least one wiring portion selected from the first wiring portion, the second wiring portion, and the third wiring portion in a state of not being in contact with the one wiring portion, and
in a case where the arc detection means detects arc discharge in the one wiring portion,
a risk degree determination operation is executed,
in the risk degree determination operation,
duration until the arc discharge is extinguished from the detection of the arc discharge in the one wiring portion is compared with a first threshold value, and
whether or not the arc discharge that has occurred reaches a first criteria for risk assessment is discriminated based on a result of the comparison with the first threshold value.

# FIG. 1A

SERIES ARC DETECTOR — 5

POWER SUPPLY MODULE — 2

POWER CONVERSION DEVICE — 3

SYSTEM POWER SUPPLY PORTION — 100

PARALLEL ARC DETECTOR — 6

CONTROL UNIT — 7

# FIG. 1B

# FIG. 2

START

S1-1
m=0, n=0

S1-2
NORMAL DRIVING

S1-3 IS SERIES ARC DETECTED? — Yes

S1-11 SERIES STOP DRIVING

S1-12 HAS SECOND TIME T2 ELAPSED? — No

S1-13 $n<b$? — No

S1-14 n=n+1

No

S1-4 IS PARALLEL ARC DETECTED? — No

Yes

S1-5 PARALLEL STOP DRIVING

S1-6 HAS FIRST TIME T1 ELAPSED? — No

Yes

S1-7 $m<a$? — No

Yes

S1-8 m=m+1

S1-16 STOP DRIVING

S1-17 HAS PREDETERMINED PERIOD T3 ELAPSED? — No

Yes

S1-18 m=0, n=0

S1-9 END PARALLEL STOP DRIVING

S1-15 END SERIES STOP DRIVING

S1-10 IS THERE DRIVING END REQUEST? — No

Yes

END

# FIG. 3

START

S2-1

$Vpv1 < Vc1$ ?

No

Yes

S2-2

FIRST SERIES ARC
INTERRUPTION
OPERATION

S2-3

SECOND SERIES ARC
INTERRUPTION
OPERATION

END

# FIG. 4

EP 4 583 341 A1

FIG. 5

EP 4 583 341 A1

FIG. 6

FIG. 7

START

S3-1 → IS ARC DISCHARGE DETECTED? — No

Yes

S3-2 → TA>T10? — No

Yes

S3-4 → JA>J1? — Yes / No

S3-5 → IS ARC DISCHARGE CONTINUED? — Yes / No

S3-3 IT IS DETERMINED THAT ARC DISCHARGE WITH HIGH RISK HAS OCCURRED

END

## FIG. 8

```
              START

S4-1
         SET FIRST RELAY
         PORTION INTO OPEN
         STATE

S4-2
         IS ARC DISCHARGE          Yes
         DETECTED?

         No                            ↓

S4-3                            S4-4
  DISCRIMINATE THAT            DISCRIMINATE THAT
  SERIES ARC DISCHARGE        PARALLEL ARC DISCHARGE
  HAS OCCURRED                HAS OCCURRED

                               S4-5
                                 SET FIRST RELAY
                                 PORTION TO
                                 CLOSED STATE AND
                                 SECOND RELAY
                                 PORTION TO
                                 CLOSED STATE

              END
```

## FIG. 9

```
              START

S5-1
         FIRST SERIES ARC
         INTERRUPTION
         OPERATION

S5-2
         IS Ipv ZERO?          Yes

         No

S5-3
         SECOND SERIES ARC
         INTERRUPTION
         OPERATION

              END
```

## INTERNATIONAL SEARCH REPORT

| | International application No. |
| | **PCT/JP2023/022616** |

**A.    CLASSIFICATION OF SUBJECT MATTER**

*H02J 1/00*(2006.01)i; *G01R 31/12*(2020.01)i; *H02H 3/05*(2006.01)i; *H02H 7/26*(2006.01)i; *H02H 11/00*(2006.01)i; *H02J 3/38*(2006.01)i; *H02J 7/35*(2006.01)i

FI:    H02J1/00 301D; H02J1/00 304G; H02J1/00 304H; H02J7/35 K; H02J7/35 G; H02J7/35 Z; H02H11/00 150; H02J3/38 110; H02H3/05 B; G01R31/12 A; H02H7/26

According to International Patent Classification (IPC) or to both national classification and IPC

**B.    FIELDS SEARCHED**

Minimum documentation searched (classification system followed by classification symbols)

H02J1/00; G01R31/12; H02H3/05; H02H7/26; H02H11/00; H02J3/38; H02J7/35

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C.    DOCUMENTS CONSIDERED TO BE RELEVANT**

| Category* | Citation of document, with indication, where appropriate, of the relevant passages | Relevant to claim No. |
|---|---|---|
| Y | WO 2022/168255 A1 (PANASONIC IP MAN CO LTD) 11 August 2022 (2022-08-11) paragraphs [0018]-[0067], fig. 1-3 | 1-2, 9 |
| A | paragraphs [0018]-[0067], fig. 1-3 | 3-8, 10-15 |
| Y | JP 2020-36511 A (TABUCHI DENKI KK) 05 March 2020 (2020-03-05) paragraphs [0014]-[0046], fig. 1-6 | 1-2, 9 |
| A | paragraphs [0014]-[0046], fig. 1-6 | 3-8, 10-15 |
| A | JP 2020-76710 A (PANASONIC IP MAN CO LTD) 21 May 2020 (2020-05-21) paragraphs [0019]-[0073], fig. 1-4 | 3-8, 10-15 |
| A | JP 2013-500476 A (ENPHASE ENERGY INC  ) 07 January 2013 (2013-01-07) paragraphs [0009]-[0041], fig. 1-4 | 3-8, 10-15 |
| A | JP 2018-117514 A (SOLAREDGE TECHNOLOGIES LTD) 26 July 2018 (2018-07-26) paragraphs [0021]-[0170], fig. 1a, 1b, 2 | 3-8, 10-15 |

☐ Further documents are listed in the continuation of Box C.      ☑ See patent family annex.

| | |
|---|---|
| *    Special categories of cited documents: | "T"   later document published after the international filing date or priority date and not in conflict with the application but cited to understand the principle or theory underlying the invention |
| "A"   document defining the general state of the art which is not considered to be of particular relevance | |
| "E"   earlier application or patent but published on or after the international filing date | "X"   document of particular relevance; the claimed invention cannot be considered novel or cannot be considered to involve an inventive step when the document is taken alone |
| "L"   document which may throw doubts on priority claim(s) or which is cited to establish the publication date of another citation or other special reason (as specified) | "Y"   document of particular relevance; the claimed invention cannot be considered to involve an inventive step when the document is combined with one or more other such documents, such combination being obvious to a person skilled in the art |
| "O"   document referring to an oral disclosure, use, exhibition or other means | |
| "P"   document published prior to the international filing date but later than the priority date claimed | "&"   document member of the same patent family |

| Date of the actual completion of the international search | Date of mailing of the international search report |
|---|---|
| **16 August 2023** | **29 August 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

## INTERNATIONAL SEARCH REPORT
### Information on patent family members

International application No.

**PCT/JP2023/022616**

| Patent document cited in search report | | | Publication date (day/month/year) | Patent family member(s) | | | Publication date (day/month/year) |
|---|---|---|---|---|---|---|---|
| WO | 2022/168255 | A1 | 11 August 2022 | (Family: none) | | | |
| JP | 2020-36511 | A | 05 March 2020 | (Family: none) | | | |
| JP | 2020-76710 | A | 21 May 2020 | (Family: none) | | | |
| JP | 2013-500476 | A | 07 January 2013 | WO | 2011/011711 | A2 | |
| | | | | paragraphs [0012]-[0044], fig. 1-4 | | | |
| | | | | US | 2011/0019444 | A1 | |
| | | | | US | 2012/0206843 | A1 | |
| | | | | EP | 2741388 | A1 | |
| | | | | CA | 2758815 | A1 | |
| | | | | KR | 10-2012-0039036 | A | |
| JP | 2018-117514 | A | 26 July 2018 | JP | 2012-112937 | A | |
| | | | | JP | 2018-38254 | A | |
| | | | | JP | 2020-114174 | A | |
| | | | | JP | 2022-110102 | A | |
| | | | | US | 2012/0112760 | A1 | |
| | | | | paragraphs [0027]-[0072], fig. 1a, 1b, 2 | | | |
| | | | | US | 2017/0170782 | A1 | |
| | | | | US | 2017/0207746 | A1 | |
| | | | | US | 2017/0288384 | A1 | |
| | | | | US | 2017/0288409 | A1 | |
| | | | | US | 2017/0346295 | A1 | |
| | | | | US | 2018/0097354 | A1 | |
| | | | | US | 2019/0173421 | A1 | |
| | | | | US | 2020/0350759 | A1 | |
| | | | | US | 2021/0167723 | A1 | |
| | | | | US | 2021/0288610 | A1 | |
| | | | | US | 2021/0351741 | A1 | |
| | | | | US | 2021/0376595 | A1 | |
| | | | | US | 2022/0140615 | A1 | |
| | | | | US | 2022/0263462 | A1 | |
| | | | | US | 2023/0006434 | A1 | |
| | | | | EP | 3229332 | A1 | |
| | | | | EP | 3252909 | A1 | |
| | | | | EP | 3291309 | A1 | |
| | | | | EP | 3349317 | A1 | |
| | | | | EP | 3683909 | A1 | |
| | | | | EP | 3687019 | A1 | |
| | | | | EP | 3687020 | A1 | |
| | | | | EP | 4016776 | A1 | |
| | | | | EP | 4024688 | A2 | |
| | | | | EP | 4096039 | A1 | |
| | | | | EP | 4152414 | A2 | |
| | | | | GB | 2485527 | A | |
| | | | | CN | 102565635 | A | |
| | | | | CN | 106093721 | A | |
| | | | | CN | 107276526 | A | |
| | | | | CN | 107437926 | A | |
| | | | | CN | 107800376 | A | |

Form PCT/ISA/210 (patent family annex) (January 2015)

<div align="center">

**INTERNATIONAL SEARCH REPORT**
**Information on patent family members**

</div>

International application No.

**PCT/JP2023/022616**

| Patent document cited in search report | Publication date (day/month/year) | Patent family member(s) | | Publication date (day/month/year) |
|---|---|---|---|---|
| | | CN | 108333491 A | |
| | | CN | 111435796 A | |
| | | CN | 113131859 A | |
| | | CN | 113708721 A | |
| | | CN | 113992147 A | |
| | | CN | 114725981 A | |
| | | CN | 114977076 A | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 6597394 A

- JP 2020036511 A